# FASCICULE DE BREVET EUROPEEN

(11) **EP 2 102 904 B1**
(45) Date de publication et mention de la délivrance du brevet: **06.12.2017**
(21) Numéro de dépôt: 07872387.1
(22) Date de dépôt: 18.12.2007
(51) Int. Cl.: H01L 21/762, H01L 21/02

(54) **PROCEDE DE FABRICATION DE COUCHES MINCES DE GAN PAR IMPLANTATION ET RECYCLAGE D'UN SUBSTRAT DE DEPART**
VERFAHREN ZUR HERSTELLUNG DÜNNER GAN-SCHICHTEN DURCH IMPLANTATION UND RECYCLING EINES STARTSUBSTRATS
METHOD FOR PREPARING THIN GAN LAYERS BY IMPLANTATION AND RECYCLING OF A STARTING SUBSTRATE

(30) Priorité: 19.12.2006 FR 0655664
(43) Date de publication de la demande: 23.09.2009
(73) Titulaire: Commissariat à l'Énergie Atomique et aux Énergies Alternatives, 75015 Paris (FR)
(72) Inventeur: TAUZIN, Aurélie, F-38120 Saint Egreve (FR); DECHAMP, Jérôme, F-38140 Beaucroissant (FR); MAZEN, Frédéric, F-38100 Grenoble (FR); MADEIRA, Florence, F-38470 Beaulieu (FR)
(74) Mandataire: Colombo, Michel
(86) Numéro de dépôt international: PCT/FR2007/002100
(87) Numéro de publication internationale: WO 2008/093008

(56) Documents cités:
- WO-A-2004/061944
- US-A1- 6 013 563
- US-A1- 2004 262 686
- US-A1- 2005 269 671

## Description

### Domaine de l'invention

L'invention concerne un procédé de fabrication de couches minces de GaN (on parle aussi de films minces) pour des applications de microtechnologie.

Le procédé connu sous la dénomination « Smart Cut ® » permet le détachement d'un film mince et son transfert sur un support parfois appelé raidisseur par les étapes suivantes :
1. bombardement d'une face d'un substrat initial avec des ions ou espèces gazeuses (H ou gaz rares), afin d'implanter ces ions (ou atomes) en concentration suffisante pour créer une couche de microcavités,
2. mise en contact intime de cette face du substrat avec un second substrat appelé support ou raidisseur (typiquement par collage moléculaire),
3. fracture au niveau de la couche de microcavités, par l'application d'un traitement thermique et/ou d'une contrainte de détachement (par exemple, l'insertion d'une lame entre les deux substrats et/ou encore des efforts de traction et/ou de flexion et/ou de cisaillement, et/ou encore l'application d'ultrasons ou de micro-ondes de puissance et de fréquence judicieusement choisies), et
4. recyclage du substrat.

Dans le cas de la réalisation d'hétérostructures, par exemple dans le cas du report d'un film mince d'un matériau A sur un substrat de matériau B, lorsque l'étape 2 de mise en contact intime des deux substrats est suivie d'un traitement thermique (consolidation de la mise en contact intime (collage), ou fracture thermique), on peut assister au décollement ou à la rupture des deux substrats collés. En effet, de par leurs propriétés intrinsèques, les matériaux différents A et B ont généralement des coefficients de dilatation thermique (CTE en abrégé) différents. Plus les CTE sont différents, moins l'intégrité de la structure collée peut être maintenue à haute température. Ainsi, dans le cas d'un substrat GaN auto-porté d'épaisseur d'environ 325 microns (notée ∼325µm) collé sur un substrat saphir d'épaisseur ∼330µm, les deux substrats collés ne doivent pas en pratique être portés à une température au-delà de 230°C environ (soit pas au-delà de ∼230°C avec la notation précitée) : en effet, au-delà de 230°C, on assiste au décollement des deux substrats, c'est-à-dire à leur détachement l'un par rapport à l'autre au niveau de l'interface de collage. Cette faible tenue en température est particulièrement problématique pour l'étape 3 de fracture, puisque cette étape est généralement constituée en tout ou partie d'un traitement thermique, or les traitements thermiques sont conduits en pratique à des températures bien supérieures. La tenue en température des collages limite donc le traitement thermique de fracture.

Il est connu par le document US - A - 5 877 070 (concernant principalement le silicium, le carbure de silicium, le germanium ou le diamant) qu'une étape de sensibilisation, par traitement thermique (à température élevée) de la plaque implantée avant l'étape de collage, permet de diminuer le traitement thermique ultérieur de fracture. Le problème est que cette étape de sensibilisation est d'effet limité : en effet, elle ne doit pas induire de déformation de la surface sous forme de cloques (ou « blisters »), voire de zones exfoliées. Cela implique en pratique que la sensibilisation ne peut pas représenter plus de 10% environ du budget thermique de fracture; il en résulte que le traitement de fracture proprement dit, après collage au raidisseur, doit donc être d'environ 90% du budget thermique de fracture. Cette sensibilisation limitée ne permet donc pas une diminution significative du traitement de fracture proprement dit, de sorte que la limitation imposée par la tenue au collage subsiste même après un tel traitement de sensibilisation. Il convient ici de rappeler que le budget thermique de fracture correspond à la durée du recuit nécessaire à l'obtention de la fracture, pour une température de recuit donnée (on comprend aisément que le temps de fracture dépend de la température de recuit) ; le budget thermique de fracture dépend des conditions d'implantation, notamment de la nature des ions (ou atomes) implantés, de leur dose, de leur énergie, du substrat implanté,...).

L'étape 2 de mise en contact intime du substrat implanté avec le raidisseur doit en principe être réalisée sur des surfaces planes et parfaitement propres. Le problème est que, lors de sa mise en oeuvre, cette mise en contact intime ne peut pas être effectivement réalisée sur toute la surface des substrats :
- tout d'abord, les bords des plaques formant les substrats sont généralement chanfreinés et ne peuvent donc pas être mis en contact ; on rencontre ce problème de non-collage en bord de plaques pour tous les matériaux (Si, Ge, GaAs, GaN, Saphir, SiGe, LiTaO3, LiNbO3, SiC, InP, etc...) et pour tous les diamètres de plaques entre 5 cm et 30 cm (entre 2 pouces et 12 pouces en pratique);
- dans le cas de substrats ou de couches structurés volontairement (par exemple par des motifs réalisés par photolithogravure) ou involontairement (par exemple par des défauts de croissance dans le cas de couches épitaxiées, ou encore par des défauts liés au dépôt d'une couche sur le substrat initial), les motifs ou les défauts qui sont en creux sur la surface donnent lieu à des zones non collées (ZNC en abrégé) ;
- enfin, dans le cas d'un nettoyage insuffisamment efficace, la présence de particules (« poussières ») à l'interface de collage donne lieu également à des ZNC.

Lors de l'étape de fracture, lorsque la dimension des ZNC est grande par rapport à l'épaisseur du film à transférer (par exemple avec un ratio (dimension latérale ZNC) / (épaisseur film) d'environ 10), le film mince reste localement solidaire du substrat initialement implanté. On parle alors de zones non transférées (ZNT en abrégé).

Ces défauts de collage peuvent même conduire à l'apparition de soulèvements voire de détachements très locaux (sur des dimensions de quelques microns carrés) du film mince, sous forme de cloques ou de zones exfoliées, ce qui est tout à fait à éviter.

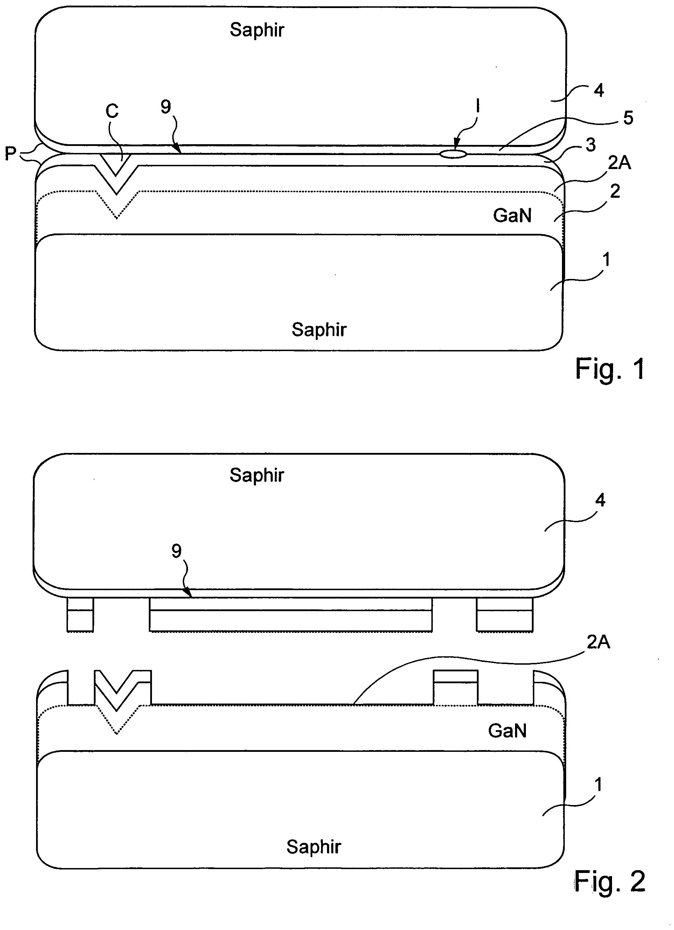

A titre d'exemple, la figure 1 représente un substrat 1, ici en saphir, sur lequel une couche 2, ici en GaN, a été déposée puis a fait l'objet d'une implantation ayant conduit à la formation d'une zone implantée 2A. Sur cette couche 2 est représentée une éventuelle couche de collage 3. Cette couche 2 est en contact intime, selon un interface 9, avec un autre substrat 4, ici aussi en saphir, également muni d'une éventuelle couche de collage 5, par exemple similaire à la couche 3.

On observe que, les substrats étant chanfreinés, les zones périphériques P ne sont pas collées. Par ailleurs, en raison d'un défaut intervenu lors du dépôt de la couche de GaN, il y a un creux dans la couche de collage 3, et donc une zone non collée C. Enfin, la référence I représente une poussière (subsistant après un nettoyage peu efficace) emprisonnée entre les surfaces de collage, et réduisant, voire supprimant, localement la tenue mécanique de l'interface de collage 9.

On observe sur la figure 2 que, lors de la fracture au niveau de la zone implantée, il subsiste des zones non transférées, à l'aplomb des zones périphériques, du défaut de croissance et de la poussière.

Selon un avantage notable de la technologie « Smart Cut ® », le substrat initialement implanté peut, après pelage d'un film mince lors de l'étape de fracture, être recyclé pour d'autres cycles analogues de transfert. Toutefois, on vient de voir que le film mince reste localement solidaire du substrat au niveau des zones non transférées, formant ainsi des marches d'épaisseur typiquement comprise entre 10 à 1000 nm (correspondant à l'épaisseur du film mince). En outre, l'implantation puis la fracture ont généralement fait apparaître des rugosités à la surface mise à nu du substrat. Il en découle que le recyclage du substrat dont un film mince vient d'être détaché nécessite généralement des étapes particulières de planarisation, notamment par polissage mécanique et/ou attaque chimique (cela est notamment expliqué dans les documents EP-A-1 427 002 et EP-A-1 427 001).

### Objet de l'invention

L'invention a pour objet de surmonter les inconvénients précités dans le cas du nitrure de gallium, c'est-à-dire de permettre le détachement d'une couche mince de GaN, ou son transfert sur un substrat-hôte, par une fracture en des temps réalistes à l'échelle industrielle, tout en formant, lors de cette fracture, des surfaces libres n'impliquant pas de traitement de planarisation significatif (car ne présentant pas les marches décrites précédemment), de manière à ce que le reliquat du substrat de départ puisse être ensuite éventuellement réutilisé (recyclé), sensiblement en l'état, pour un nouveau cycle de formation d'un film mince. L'invention a également pour objet de permettre un transfert sur un substrat-hôte à des températures suffisamment faibles pour ne pas risquer un décollement entre le substrat de départ et le substrat-hôte en raison d'une différence trop importante entre les coefficients de dilatation thermique de ces substrats.

L'invention propose à cet effet un procédé de fabrication d'une couche mince en GaN à partir d'un substrat de départ dont au moins une zone épaisse de surface longeant une face libre de substrat de départ est en GaN, comprenant les étapes suivantes :
- bombardement de ladite face libre du substrat de départ avec des ions Hélium et Hydrogène,
- application au substrat de départ d'un traitement de fracture propre à provoquer le détachement, vis-à-vis d'un reliquat du substrat de départ, de toute la partie de la zone épaisse de GaN située entre la face libre et la profondeur d'implantation de l'hélium et de hydrogène, caractérisée en ce que l'hélium est implanté en premier dans l'épaisseur de ladite zone épaisse et l'hydrogène est implanté en second, les doses d'hélium et d'hydrogène étant chacune comprise entre 1.10¹⁷ atomes/cm² et 4.10¹⁷ atomes/cm².

Il est apparu que les conditions de l'invention permettent, au niveau du phénomène de détachement, l'obtention de surfaces de faible rugosité (sans marche significative), et ce pour des températures suffisamment faibles pour ne pas risquer de décollement en cas de transfert sur un substrat-hôte.

Il est à noter que les conditions d'implantation déterminent les profondeurs d'implantation.

Selon des caractéristiques avantageuses de l'invention, éventuellement combinées :
- la dose d'implantation de l'hélium est au moins égale à la dose d'implantation de l'hydrogène,
- le reliquat du substrat de départ après fracture (ou détachement) est recyclé ; dans ce cas, le procédé comporte avantageusement en outre un traitement de préparation du reliquat du substrat de départ, avant son recyclage, impliquant au plus un polissage d'au plus un micron d'épaisseur (typiquement de l'ordre de 0,2 microns), voire pas de traitement du tout,
- le substrat de départ est, avant le détachement, mis en contact intime avec un substrat-hôte par ladite face libre ; de manière avantageuse, cette mise en contact intime est un collage moléculaire ; de préférence, au moins une couche est déposée sur la surface libre du substrat de départ avant mise en contact intime avec le substrat-hôte, en vue notamment de la protection de l'une ou l'autre de ces surfaces ou pour faciliter le collage,
- le traitement de fracture comporte l'application au substrat de départ, avant une telle mise en contact intime, un traitement de fragilisation comportant un traitement thermique et correspondant à au moins 85% du budget thermo-mécanique nécessaire pour obtenir la fracture de ce substrat de départ au niveau de la profondeur d'implantation de l'hydrogène,
- ce traitement de fragilisation comporte avantageusement une étape de dépôt d'une couche sous forme vapeur,
- ce traitement de fragilisation comporte avantageusement l'application de contraintes mécaniques (par exemple une mise sous tension légère, du fait du contact avec une couche ayant des propriétés thermiques différentes mais ayant une épaisseur faible (typiquement inférieure à de l'ordre du micron),
- ce traitement thermique de fragilisation est de préférence effectué à une température d'au plus 400 °C, de préférence au plus égale à 300 °C,
- ce traitement de fragilisation est par exemple principalement constitué d'un traitement thermique de fragilisation effectué pendant au moins 85 % du temps nécessaire pour obtenir une fracture thermique,
- ce traitement de fragilisation correspond avantageusement à un budget thermo-mécanique d'au moins 95% du budget nécessaire pour obtenir le détachement de la couche mince ; il peut théoriquement être choisi supérieur à 99%, voire 99.99%, mais pour garantir que le substrat de départ conserve une tenue mécanique suffisante pour son éventuelle mise en contact intime avec un substrat-hôte, ce budget est de préférence au plus égal à 99% du budget nécessaire pour la fracture,
- le traitement résiduel de fracture est avantageusement effectué à une température au plus égale à 250 °C, par exemple à la température ambiante,
- ce traitement comporte avantageusement l'application de contraintes mécaniques, de préférence à la température ambiante,
- le traitement résiduel de fracture comporte l'application d'un traitement thermique et/ou d'une contrainte de détachement, par exemple par application d'ultrasons et/ou de micro-ondes (de puissance et de fréquence judicieusement choisies),
- la dose d'implantation d'hélium est de préférence comprise entre 1.10¹⁷ et 2.10¹⁷ He⁺/cm² (de préférence de l'ordre de 2.10¹⁷ He⁺/cm²) et la dose d'implantation d'hydrogène est avantageusement comprise dans la même gamme (1.10¹⁷ et 2.10¹⁷ H⁺/cm²), de préférence de l'ordre également de 2.10¹⁷ H⁺/cm²) ; ainsi, de manière avantageuse, les doses d'implantation d'hydrogène et d'hélium sont chacune sensiblement égale à 2.10¹⁷ atomes/cm²,
- la dose cumulée d'implantation est comprise entre 3.10¹⁷ atomes/cm² et 4.5 10¹⁷ atomes/cm², de préférence entre 3.5 10¹⁷ atomes/cm² et 4 10¹⁷ atomes/cm², environ,
- l'énergie d'implantation pour l'étape d'implantation d'hélium est supérieure à l'énergie d'implantation pour l'étape d'implantation d'hydrogène,
- l'énergie d'implantation d'hélium est comprise entre 90 keV et 210 keV et l'énergie d'implantation d'hydrogène est comprise entre 60 keV et 120 keV,
- le procédé comporte avantageusement, en outre, un traitement thermique de finition conduisant à parfaire le détachement de toute la couche mince, y compris dans d'éventuelles zones non collées.

Il est à noter que le principe d'une co-implantation d'hydrogène et d'hélium a déjà été proposé, notamment en vue d'obtenir pour le film mince une surface libre de bonne rugosité. On peut citer à cet égard les documents WO - A - 2004/044976, WO - A - 2004/042779, WO - A - 2005/013318 et WO - A - 2005/043615. Toutefois, ces documents prévoient en pratique de profiter de la présence des deux éléments d'implantation pour diminuer autant que possible la dose d'implantation de chacun des éléments en dessous de 5.10¹⁶ at/cm², un collage du premier substrat à un second substrat avant tout traitement thermique important, et le plus souvent des traitements thermiques à des températures élevées.

Par ailleurs, les documents US-2004/0262686 et US-2005/0269671 ont déjà proposé des étapes de transfert à partir de nitrure de gallium mettant en oeuvre, dans du nitrure de gallium, une co-implantation d'hydrogène et d'hélium, mais avec des doses inférieures à celles proposées par l'invention et sans préciser l'ordre d'implantation (le second document précité ne fait que mentionner la possibilité d'une co-implantation, sans en préciser les modalités). Ces documents ne s'intéressent pas à la qualité de surface résultant du détachement de la couche mince et ne peuvent donc pas avoir identifié en quoi l'ordre et les doses d'implantation peuvent avoir des conséquences sur la qualité de cette qualité de surface.

Il faut noter à cet égard que, compte tenu de ce que l'implantation conduit à une perturbation du réseau cristallin sur une certaine épaisseur, le souci d'avoir pour le film mince une surface arrière bien nette et plane avait a priori pour conséquence que la surface du substrat de départ mise à nu du fait du détachement de la couche mince était sensiblement dégradée, surtout lorsque les doses étaient importantes. L'invention est pourtant fondée sur la constatation que des choix appropriés des conditions d'implantation permettent d'obtenir les avantages mentionnés ci-dessus.

Sans que les mécanismes physiques aient été élucidés, il semble que les atomes d'hélium diffusent vers les défauts créés par l'hydrogène pour les mettre sous tension ; compte tenu de la forte dose d'implantation d' l'hydrogène, comparable à celle couramment utilisée pour provoquer une fracture par elle seule, l'implantation additionnelle d'hélium permet de conférer aux défauts générés par l'implantation d'hydrogène une efficacité optimale, de sorte que leur coalescence se produit de manière bien nette, d'où la formation d'un interface de séparation bien propre.

Il est même apparu que, dès lors de la dose cumulée d'implantation est importante, c'est-à-dire au moins égale à 3.10¹⁷ atomes/cm², la présence d'hydrogène n'était pas nécessaire.

C'est ainsi que, selon un autre aspect de l'invention, celle-ci propose un procédé de fabrication d'une couche mince en GaN à partir d'un substrat de départ dont au moins une zone épaisse de surface longeant une face libre du substrat de départ est en GaN, comprenant les étapes suivantes :
- bombardement de ladite face libre du substrat de départ avec des ions Hélium puis, optionnellement, des ions Hydrogène, l'Hélium étant implanté en premier dans l'épaisseur de ladite zone épaisse, la dose cumulée d'implantation étant comprise entre 3.10¹⁷ atomes/cm² et 4.5 10¹⁷ atomes/cm² en étant constituée au moins en majorité en Hélium,
- application au substrat de départ d'un traitement de fracture propre à provoquer le détachement, vis-à-vis d'un reliquat du substrat de départ, de toute la partie de la zone épaisse de GaN située entre la face libre et la profondeur d'implantation de l'hélium.

De manière avantageuse, la dose d'implantation est entièrement constituée d'Hélium, à de l'ordre de 4.10¹⁷ atomes/cm² environ (c'est-à-dire entre 3.5 10¹⁷ atomes/cm² et 4.5 10¹⁷ atomes/cm², voire entre 3.75 10¹⁷ atomes/cm² et 4.25 10¹⁷ atomes/cm²)_{.}

En fait qu'il y ait une co-implantation d'hélium et d'hydrogène ou une implantation d'hélium seul, l'invention conduit à une délamination qui s'étend aisément à toute la section du substrat de départ (quitte à prolonger le traitement de fracture), donc indépendamment de l'existence de défauts locaux de collage, ou de l'absence de collage en périphérie ; cela contribue à garantir que la surface mise à nu sur le reliquat du substrat de départ est propre et nette.

Des objets, caractéristiques et avantages de l'invention ressortent de la description qui suit, donnée en regard des dessins annexés, sur lesquels :
- la figure 1 est un schéma de principe représentant un ensemble d'un substrat en GaN déposé sur un substrat en saphir et ayant fait l'objet d'une implantation, collé à un autre substrat en saphir, mais présentant des zones non collées,
- la figure 2 est un schéma de principe représentant l'ensemble de la figure 1, après séparation au niveau de la zone implantée, mais présentant des zones non transférées,
- la figure 3 est un schéma d'une première étape d'implantation d'un procédé conforme à l'invention,
- la figure 4 est un schéma d'une seconde étape d'implantation de ce procédé,
- la figure 5 est un schéma d'une étape de traitement thermique de ce procédé,
- la figure 6 est un schéma de mise en contact intime avec un second substrat, et
- la figure 7 est un schéma représentant la séparation du substrat de départ en une couche mince et un reliquat de substrat, prêt à être recyclé.

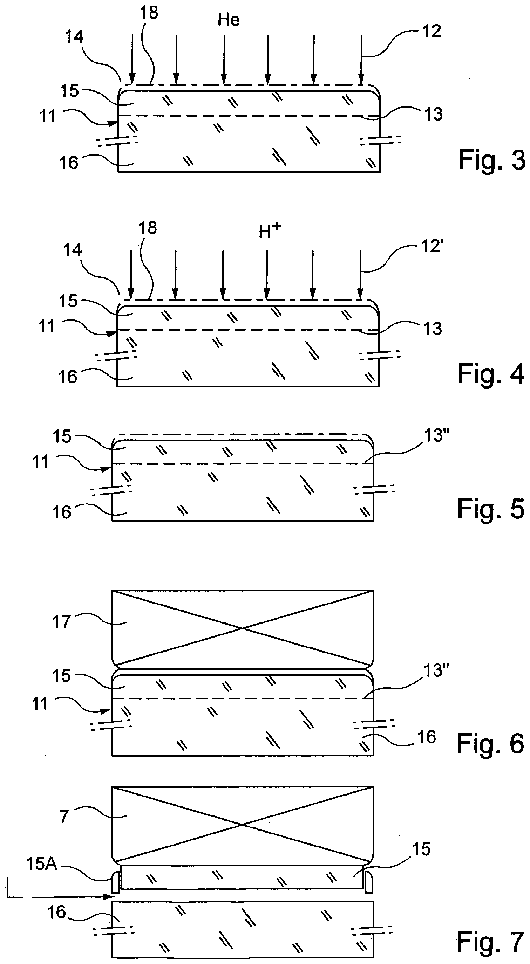

Les figures 3 à 7 représentent les principales étapes d'un exemple de procédé de fabrication d'une couche mince de GaN conforme à l'invention :
- 1) - première implantation d'un substrat de départ 11 en GaN, au moyen d'un bombardement d'hélium, schématisé par des flèches 12, en sorte de former une couche implantée notée 13, cette implantation étant faite à une dose comprise entre de l'ordre de 10¹⁷/cm² et de l'ordre de 4.10¹⁷/cm²,
- 2) - seconde implantation de ce substrat de départ 11, au moyen d'un bombardement d'hydrogène, schématisé par les flèches 12', cette implantation étant faite à une dose comprise entre de l'ordre de 10¹⁷/cm² et 4.10¹⁷/cm²,
- 3) - étape de traitement de fragilisation, comportant en pratique un traitement thermique, de préférence à température basse, pendant une durée donnée, ce traitement correspondant à l'application d'un budget thermique (ou thermo-mécanique s'il y a une application de contraintes mécaniques) représentant avantageusement au moins 85% du budget thermique (ou thermo-mécanique) qui serait nécessaire pour obtenir une séparation ou fracture par ce seul traitement thermique,
- 4) - mise en contact intime de ce substrat implanté avec un second substrat 17, aussi appelé substrat-hôte,
- 5) - application d'un traitement résiduel de fracture, en sorte de séparer le substrat de départ en une couche mince 15 (y compris des éventuels morceaux résiduels 15A) et en un reliquat 16 de substrat, prêt à être recyclé et à subir à nouveau les étapes d'implantation précitées.

Les étapes 3 à 5 constituent conjointement un traitement de fracture propre à provoquer le détachement, vis-à-vis du reliquat du substrat de départ, de toute la partie de la zone de GaN située entre la face libre par laquelle l'implantation a été effectuée et la profondeur d'implantation de l'hydrogène. Dans une version particulièrement simple, le procédé de l'invention se limite, par exemple, à l'étape 3 conduite jusqu'au détachement de la couche mince désirée.

Le substrat de départ 11 est ici entièrement constitué de GaN. En variante, comme dans le cas de la figure 1, il peut s'agir d'un substrat dont seulement une zone épaisse de surface, longeant la face libre du substrat, est en GaN, cette zone étant une couche portée par un support éventuellement constitué en saphir. Cette zone est suffisamment épaisse pour que les implantations soient réalisées dans l'épaisseur de cette zone.

La notion de budget thermique (ou de budget thermo-mécanique) correspond à l'énergie apportée, sous forme thermique, ou thermo-mécanique, conduisant à la fracture et le pourcentage indiqué est en pratique donné en référence au temps qui serait nécessaire pour atteindre cette énergie, à température et à contrainte (s'il y en a) constantes.

Le traitement thermique de l'étape 3, combiné ou non à l'application de contraintes, provoque l'évolution des défauts introduits par les implantations en sorte de former une couche fragilisée 13", sensiblement au niveau de la couche 13, séparant la future couche mince 15 et le futur reliquat 16. La surface 14 peut être recouverte d'une couche de protection 18, par exemple en oxyde, avant ou après les étapes d'implantation, cette couche 18 pouvant être, ou non, retirée avant la mise en contact avec le second substrat (étape 4).

L'invention réside notamment dans le choix particulier des conditions d'implantation dans le GaN, qui ont pour effet que les étapes 1 et 2 conduisent à la formation de défauts qui évoluent en température selon un mode particulier. Ainsi, il est connu de l'homme du métier qu'une implantation d'ions gazeux (H, He,...) dans un substrat (Si, Ge, GaN,...) entraîne la formation de défauts et microcavités à une profondeur qui dépend principalement des ions implantés, du substrat et de l'énergie d'implantation. Lorsqu'on applique un traitement thermique au substrat implanté (sans collage préalable à un raidisseur), les défauts évoluent normalement en taille et en densité jusqu'à former, sensiblement à la profondeur d'implantation, des microfissures contenant une phase gazeuse de l'ion implanté. Ces microfissures, sous l'effet de la pression du gaz, entraînent alors des déformations locales de la surface libre du substrat sous forme de cloques, voire des détachements locaux sous forme d'exfoliations.

Par contre, les conditions d'implantation préconisées par l'invention entraînent la formation dans du GaN de défauts qui évoluent différemment en température. En effet, ces conditions originales conduisent, après un traitement thermique approprié, même sans application d'un substrat raidisseur, à un détachement total du film superficiel implanté 15, sans formation de cloques ou d'exfoliations locales. Cette délamination est apparue être liée à la particularité des défauts d'implantation générés par les conditions prévues par l'invention, et non pas à une énergie d'implantation limite (voir le document WO-A-2003/063213 qui enseigne une relation entre dose et énergie d'implantation pour obtenir, au cours d'un traitement de fracture entièrement exécuté après collage à un raidisseur, à une exfoliation sensiblement complète).

Il en découle que les conditions d'implantation et de traitement thermique de l'invention sont capables de provoquer pour le GaN une fracture complète du substrat de départ au niveau de la zone d'implantation de l'hydrogène, sans que la présence d'un raidisseur efficace soit nécessaire (ainsi que le pensait l'homme de métier).

Puisque la présence d'un raidisseur n'est pas nécessaire pour éviter des exfoliations locales ou pour maintenir la planéité de la couche délaminée, l'invention enseigne de conduire avantageusement le traitement thermique (dit de « surfragilisation ») sans substrat raidisseur, c'est-à-dire sans raidisseur massif (d'épaisseur supérieure à plusieurs microns), donc sans limite due à une éventuelle différence de coefficient de dilatation thermique entre les deux substrats ; et ce traitement peut être conduit « presque jusqu'au bout », de manière à permettre (si cela est souhaité), juste avant la séparation, la fixation à un éventuel substrat devant faciliter la manipulation de la couche mince après séparation (il est rappelé que, en pratique, la séparation d'une couche mince vis-à-vis d'un reliquat de substrat de départ, après que ce substrat de départ a été fixé à un second substrat, est qualifiée d'étape de transfert, puisque la couche mince, faisant initialement partie du substrat de départ, est finalement solidaire du second substrat). Grâce à l'invention, même les zones non collées au second substrat (en particulier les zones périphériques, les zones de défaut du substrat, les zones de défaut de collage correspondant aux de zones P, C et I de la figure 1) se détachent grâce à un traitement de fracture approprié.

Selon un aspect de l'invention, ce traitement thermique peut être accompagné de contraintes mécaniques.

Cette étape de « surfragilisation », ne doit pas, si l'on veut effectuer un transfert, être effectuée jusqu'à aboutir à une fracture au niveau de la couche de microcavités, mais il peut avantageusement représenter au moins 85%, voire 85% ou même au moins 99% (par exemple 99.99%) du budget thermique (et/ou thermo-mécanique) de fracture, même s'il peut paraître prudent, pour éviter une fracture intempestive, de ne pas dépasser 99%, par exemple.

L'étape de mise en contact intime avec le second substrat 7 formant hôte est avantageusement réalisée par collage (de préférence un collage moléculaire), et peut impliquer l'utilisation d'une couche de collage déposée sur la surface 14 du substrat GaN en complément ou en remplacement de la couche de protection 18.

Un traitement thermique de renforcement de ce collage peut être prévu, qui participe ou non à l'évolution des défauts de la couche 13" (le budget thermique comporte ainsi deux étapes).

L'étape finale de fracture consiste en un traitement thermique et/ou mécanique. Le budget thermo-mécanique à appliquer est d'autant plus réduit que le traitement de surfragilisation a été important. L'étape de transfert du film mince sur le second substrat peut être réalisée à la température ambiante, donc sans traitement thermique, par simple application de contraintes mécaniques, par exemple par insertion d'une lame.

Toutefois, comme il peut s'avérer difficile d'appliquer un traitement mécanique au niveau de certaines zones non collées, on choisit avantageusement un traitement thermique pour le détachement des zones à l'aplomb de ces zones non collées.

En conséquence de l'étape de fracture, le film mince 15 se détache entièrement du substrat initialement implanté, y compris au niveau des zones localement non collées telles que celles repérées C ou I à la figure 1, et y compris au niveau de la périphérie (référence P à la figure 1). Le détachement de ces zones P (voire des zones C ou I) peut être simultané au détachement de la partie utile (il s'agit en pratique de la partie centrale du film) transférée sur le second substrat (suite au traitement thermique approprié par exemple) ou nécessiter un traitement de fracture spécifique, avant ou après détachement de cette partie utile. Le recyclage du substrat initial 1, après fracture complète, ne nécessite donc aucune étape lourde de planarisation mécanique et/ou chimique pour retirer des zones non transférées (comme c'est actuellement le cas dans le cadre d'un procédé standard).

Selon les applications, le recyclage peut faire l'objet d'une préparation consistant en une simple étape de polissage mécano-chimique léger qui permet de diminuer la rugosité de surface après fracture avec un minimum d'enlèvement de matière (d'au plus un micron, typiquement de l'ordre de la centaine de nm ou de l'ordre de 0.2 microns). Selon les besoins, les substrats peuvent être recyclés directement après l'étape de fracture, sans aucun traitement de surface particulier, par exemple pour réaliser d'autres transferts de GaN.

Des exemples particuliers de mise en oeuvre du procédé de l'invention sont décrits ci-dessous.

### Exemple 1 :

Un substrat GaN (⁷⁰Ga ¹⁴N) cristallin est implanté avec des ions He dans les conditions suivantes : énergie = 90keV, dose = 2.10¹⁷ cm⁻², puis avec des ions H dans les conditions suivantes : énergie = 60keV, dose = 2.10¹⁷ cm⁻². Une couche de protection de SiO₂ d'épaisseur pouvant être choisie entre 500nm et 1µm est ensuite déposée par PECVD (Plasma Enhanced Chemical Vapor Déposition) sur le substrat implanté. Un recuit de surfragilisation de 280°C - 1h (c'est-à-dire pendant 1 heure à 280°C sans contrainte mécanique additionnelle) est ensuite appliqué.

Il est précisé qu'un recuit de 280°C -1h représente ∼85% du budget thermique de fracture à 280°C, puisque dans ces conditions la fracture est obtenue après 280°C-1h10.

Il a été constaté que les profondeurs d'implantation ainsi obtenues étaient de 390 nm pour He et de 450 nm pour l'hydrogène, c'est-à-dire qu'elles étaient sensiblement égales (à 60 nm près).

Par ailleurs, l'opération même de dépôt PECVD de la couche de protection peut induire un échauffement et donc contribuer à la surfragilisation du substrat.

Le substrat GaN est ensuite collé par adhésion moléculaire sur un raidisseur massif en saphir, selon les étapes suivantes :
- nettoyage chimique des substrats GaN et Saphir,
- polissage mécano-chimique,
- mise en contact des substrats.

La fracture est ensuite provoquée au niveau de la couche implantée par un traitement thermique. Le GaN et le Saphir ayant des coefficients de dilatation thermique différents (GaN: ∼5.8.10⁻⁶/K, Saphir: ∼8.10⁻⁶/K), la température du traitement thermique de fracture doit être suffisamment faible pour éviter un décollement de la structure. Il a été ici considéré que le traitement thermique de fracture doit être réalisé à T°<230°C. La surfragilisation permet alors d'obtenir une fracture à 230°C en ∼13h. Sans l'étape de surfragilisation, le temps de fracture (c'est-à-dire le budget thermique de fracture) aurait été de 88h à 230°C.

Cette étape de fracture 230°C-13h entraîne le détachement d'un film (ou couche mince) de GaN d'épaisseur ∼480nm, en principe sur toute la surface du substrat GaN implanté. Toutefois, il arrive qu'on obtienne d'abord une partie centrale du film de GaN qui est transférée sur le substrat saphir (on obtient ainsi une structure GaN/SiO₂/Saphir qui peut être utilisée par exemple pour la réalisation de diodes de type LED). Une autre partie localisée sur la couronne du substrat GaN est détachée du substrat sous forme d'une membrane auto-portée en forme de couronne (symbolisée par la couronne 15A à la figure 7). Le reliquat 16 du substrat GaN 11 initialement implanté peut alors être recyclé directement après la fracture pour effectuer plusieurs transferts successifs, sans étape intermédiaire de préparation de surface spécifique entre chaque cycle de transfert, les étapes précitées étant désormais appliquées à ce reliquat 6, puis au reliquat de ce reliquat après un nouveau transfert, et ainsi de suite.

Il a été vérifié que des photos représentant le reliquat d'un transfert classique (après implantation d'hydrogène) montrent très clairement un changement d'apparence en partie périphérique, ainsi qu'en des endroits localisés (à l'intérieur de la zone centrale), alors que des photos prises dans les mêmes conditions ont révélé une apparence tout à fait homogène après fracture suivant les étapes décrites ci-dessus.

### Exemple 2 :

Un substrat GaN (⁷⁰Ga ¹⁴N) cristallin est recouvert d'une couche de collage SiO₂ d'épaisseur 500nm, déposée par LPCVD (Low Pressure Chemical Vapor Déposition) à 900°C. Ce substrat est implanté avec des ions He dans les conditions suivantes : énergie = 210keV, dose = 2.10¹⁷ cm⁻², puis avec des ions H dans les conditions suivantes: énergie = 120keV, dose = 2.10¹⁷ cm⁻². Un recuit de surfragilisation de 300°C - 44min est ensuite appliqué.

Il est précisé qu'un recuit de 300°C-44min représente ∼97.7% du budget thermique de fracture à 300°C puisque, dans ces conditions, la fracture est obtenue après 300°C-45min.

Il a été constaté que les profondeurs d'implantation ainsi obtenues étaient de 750 nm pour He et de 700 nm pour l'hydrogène, c'est-à-dire qu'elles étaient sensiblement égales (à 50 nm près).

Le substrat GaN avec la couche de collage est ensuite collé par adhésion moléculaire sur un substrat saphir. La fracture est ensuite provoquée au niveau de la couche implantée par un traitement thermique à T°<230°C. La surfragilisation permet alors d'obtenir une fracture à 220°C en ∼ 16h. Sans l'étape de surfragilisation, le temps de fracture (c'est-à-dire le budget thermique de cette étape finale de fracture) aurait été de 30 jours à 220°C.

L'étape de fracture 220°C-16h entraîne le détachement d'un film de GaN d'épaisseur ∼480nm et de la couche de collage SiO₂ 500nm sur toute la surface du substrat GaN implanté. Comme indiqué ci-dessus à propos de l'exemple 1, une partie du film de GaN est transférée sur le substrat saphir ; on obtient ainsi une structure GaN/SiO2/Saphir qui peut être utilisée par exemple pour la réalisation de diodes de type LED. Une autre partie, localisée sur la couronne du substrat GaN, est détachée du substrat sous forme d'une membrane auto-portée. Le substrat GaN initialement implanté est alors recyclé pour d'autres transferts, après une étape de simple re-surfaçage par CMP (par exemple, quelques secondes de polissage mécano-chimique) afin d'éliminer la rugosité liée à la fracture.

### Exemple 3 :

Un substrat GaN (⁷⁰Ga ¹⁴N) cristallin est recouvert d'une couche de collage SiO₂ d'épaisseur 250nm, déposée par PECVD (Plasma Enhanced Chemical Vapor Deposition) à 300°C. Ce substrat est implanté avec des ions He dans les conditions suivantes : énergie = 90keV, dose = 3.10¹⁷ cm⁻², puis avec des ions H dans les conditions suivantes : énergie = 60keV, dose = 10¹⁷ cm⁻². Un recuit de surfragilisation de 495°C - 4h10min est ensuite appliqué. Il est précisé qu'un recuit de 495°C-4h10min représente ∼98% du budget thermique de fracture à 495°C puisque dans ces conditions la fracture est obtenue après 495°C-4h15.

Il a été constaté que les profondeurs d'implantation ainsi obtenues étaient de 390 nm pour He et de 450 nm pour l'hydrogène, c'est-à-dire qu'elles étaient sensiblement égales (à 60 nm près).

Le substrat GaN avec la couche de collage est ensuite collé par adhésion moléculaire sur un substrat saphir. Le collage est ensuite consolidé par un recuit à basse température, par exemple 150°C-2h. Ce type de recuit ne contribue pas à surfragiliser de manière significative le substrat GaN implanté, cette température de recuit étant trop basse ; il n'apporte donc pas de contribution au budget énergétique déjà apporté au support de départ.

La fracture est ensuite provoquée au niveau de la couche implantée par l'application de contraintes mécaniques. Pour cela une lame est par exemple insérée entre les deux substrats collés (voir la flèche L à la figure 7). Une partie du film de GaN est transférée sur le substrat saphir, on obtient ainsi une structure GaN/SiO2/Saphir qui peut être utilisée par exemple pour la réalisation de diodes de type LED. Puisque le traitement résiduel de fracture est essentiellement mécanique, des parties non suffisamment collées (zones d'exclusion, ZNC,...) ne sont pas détachées du substrat GaN, mais un recuit à 400°C-1min permet d'éliminer ces zones résiduelles sur le substrat GaN sous forme d'une membrane auto-portée. L'intégralité du film GaN est donc alors détachée, et on obtient sur le reliquat du substrat de départ une surface plane, sans relief. Ce reliquat du substrat GaN initialement implanté peut alors être recyclé pour d'autres transferts.

Des délaminations de qualité dans un substrat de GaN ont en fait été constatées, dans les conditions d'implantation précitées, pour des couples très variés de doses en hélium et en hydrogène, respectivement, entre 10¹⁷ atomes/cm² et 4.10¹⁷ atomes/cm², notamment les couples suivants dont on peut noter qu'ils correspondent à des doses totales comprises entre 3 et 4, préférentiellement entre 3.5 et 4 (en unités correspondant à 10¹⁷ atomes/cm²) :

| | | |
|---|---|---|
| - He = 2 | H = 1 | soit un total de 3, |
| - He = 2 | H = 1.5 | soit un total de 3.5, |
| - He = 1.75 | H = 2 | soit un total de 3.75, |
| - He = 2 | H = 2 | soit un total de 4, et |
| - He = 3 | H = 1 | soit un total de 4. |

On a même constaté une délamination de qualité avec, dans les mêmes conditions d'implantation que précédemment, une implantation de hélium seul, c'est-à-dire avec He=4 et H=0.

Cela permet de conclure que, dans cette gamme de doses d'implantation, si la dose d'implantation de l'hélium est suffisamment élevée, (au moins égale à 3.10¹⁷ atomes/cm² environ, typiquement entre 3.5 10¹⁷ atomes/cm² et 4.5 10¹⁷ atomes/cm², voire entre 3.75 10¹⁷ atomes/cm² et 4.25 10¹⁷ atomes/cm², on obtient également une très bonne délamination, avec une bonne qualité de surface sur les faces obtenues par la fracture, en l'absence d'implantation complémentaire d'hydrogène.

## Revendications

1. Procédé de fabrication d'une couche mince en GaN à partir d'un substrat de départ dont au moins une zone épaisse de surface longeant une face libre de substrat de départ est en GaN, comprenant les étapes suivantes :
- bombardement de ladite face libre du substrat de départ (11) avec des ions Hélium (12) et Hydrogène, (12')
- application au substrat de départ d'un traitement de fracture propre à provoquer le détachement, vis-à-vis d'un reliquat du substrat de départ, de toute la partie de la zone épaisse de GaN (15) située entre la face libre et la profondeur (13) d'implantation de l'hélium et de l'hydrogène, **caractérisée en ce que** l'hélium est implanté en premier dans l'épaisseur de ladite zone épaisse et l'hydrogène est implanté en second, les doses d'hélium et d'hydrogène étant chacune comprise entre 1.10¹⁷ atomes/cm² et 4.10¹⁷ atomes/ cm².

2. Procédé selon la revendication 1, **caractérisé en ce que** la dose d'implantation de l'hélium est au moins égale à la dose d'implantation de l'hydrogène,

3. Procédé selon la revendication 1 ou la revendication 2, **caractérisé en ce que** le reliquat du substrat de départ après fracture est recyclé et **en ce qu'**il comporte en outre un traitement de préparation du reliquat du substrat de départ, avant son recyclage, impliquant au plus un polissage d'au plus 1 micron d'épaisseur.

4. Procédé selon l'une quelconque des revendications 1 à 3, **caractérisé en ce que** le substrat de départ est, avant le détachement, mis en contact intime avec un substrat-hôte par ladite face libre.

5. Procédé selon la revendication 4, **caractérisé en ce que** le traitement de fracture comporte l'application au substrat de départ, avant cette mise en contact intime, un traitement de fragilisation comportant un traitement thermique et correspondant à au moins 85% du budget thermo-mécanique nécessaire pour obtenir la fracture de ce substrat de départ au niveau de la profondeur d'implantation de l'hydrogène, puis après cette mise en contact intime, l'application d'un traitement résiduel de fracture.

6. Procédé selon la revendication 5, **caractérisé en ce que** le traitement de fragilisation comporte l'application de contraintes mécaniques.

7. Procédé selon la revendication 5 ou la revendication 6, **caractérisé en ce que** le traitement thermique de fragilisation est effectué à une température d'au plus 400 °C.

8. Procédé selon l'une quelconque des revendications 5 à 7, **caractérisé en ce que** le traitement résiduel de fracture comporte un traitement thermique et est effectué à une température au plus égale à 250°C.

9. Procédé selon la revendication 5 à 8, **caractérisé en ce que** le traitement résiduel de fracture comporte l'application de contraintes mécaniques et est effectué à la température ambiante.

10. Procédé selon la revendication 9, **caractérisé en ce que** le traitement résiduel de fracture comporte l'application d'ultrasons ou l'application de micro-ondes.

11. Procédé selon l'une quelconque des revendications 1 à 10, **caractérisé en ce que** la dose d'implantation d'hélium est comprise entre 1.10¹⁷ et 2.10¹⁷ He⁺/cm² et **en ce que** la dose d'implantation d'hydrogène est comprise dans la gamme de 1.10¹⁷ et 2.10¹⁷ H⁺/cm².

12. Procédé selon l'une quelconque des revendications 1 à 11, **caractérisé en ce que** la dose cumulée d'implantation est comprise entre 3.10¹⁷ atomes/cm² et 4.5 10¹⁷ atomes/cm², environ.

13. Procédé selon l'une quelconque des revendications 1 à 12, **caractérisé en ce que** l'énergie d'implantation pour l'étape d'implantation d'hélium est supérieure à l'énergie d'implantation d'hydrogène.

14. Procédé de fabrication d'une couche mince en GaN à partir d'un substrat de départ dont au moins une zone épaisse de surface longeant une face libre du substrat de départ est en GaN, comprenant les étapes suivantes :
- bombardement de ladite face libre du substrat de départ (11) avec des ions Hélium (12) puis, optionnellement, des ions Hydrogène, (12') l'hélium étant implanté en premier dans l'épaisseur de ladite zone épaisse, la dose cumulée d'implantation étant comprise entre 3.10¹⁷ atomes/cm² et 4.5 10¹⁷ atomes/cm² en étant constituée au moins en majorité en Hélium,
- application au substrat de départ d'un traitement de fracture propre à provoquer le détachement, vis-à-vis d'un reliquat du substrat de départ, de toute la partie de la zone épaisse de GaN (15) située entre la face libre et la profondeur (13) d'implantation de l'hélium.

15. Procédé selon la revendication 14, **caractérisé en ce que** la dose d'implantation est entièrement constituée d'hélium, à de l'ordre de 4.10¹⁷/cm² environ.

## Patentansprüche

1. Verfahren zur Herstellung einer GaN-Dünnschicht auf Grundlage eines Ausgangssubstrats, wobei mindestens ein verstärkter Oberflächenbereich desselben, welcher sich entlang einer freiliegenden Fläche des Ausgangssubstrats erstreckt, aus GaN ist, wobei es die folgenden Schritte umfasst:
- Beschuss der freiliegenden Fläche des Ausgangssubstrats (11) mit Helium(12)- und Wasserstoff(12')-Ionen,
- Anwenden einer Aufbrechbehandlung auf das Ausgangssubstrat, wobei diese dazu geeignet ist, das Loslösen des gesamten Abschnitts des verstärkten GaN-Bereichs (15), welcher sich zwischen der freiliegenden Fläche und der Eindringtiefe (13) des Heliums und des Wasserstoffs befindet, von einem Überrest des Ausgangssubstrats zu bewirken, **dadurch gekennzeichnet, dass** das Helium als erstes in Tiefenrichtung des verstärkten Bereichs eindringen gelassen wird und der Wasserstoff als zweites eindringen gelassen wird, wobei die Dosen an Helium und an Wasserstoff jeweils im Bereich von 1.10¹⁷ Atomen/cm² bis 4.10¹⁷ Atomen/cm² liegen.

2. Verfahren nach Anspruch 1, **dadurch gekennzeichnet, dass** die eindringende Dosis an Helium mindestens der eindringenden Dosis an Wasserstoff entspricht.

3. Verfahren nach Anspruch 1 oder Anspruch 2, **dadurch gekennzeichnet, dass** der Überrest des Ausgangssubstrats nach dem Aufbrechen wiederverwendet wird, und dadurch, dass es im Vorfeld von dessen Wiederverwendung weiterhin eine Aufbereitungsbehandlung des Überrests des Ausgangssubstrats aufweist, welche mit mindestens einem Poliervorgang von höchstens 1 Mikrometer Wirktiefe einhergeht.

4. Verfahren nach einem beliebigen der Ansprüche 1 bis 3, **dadurch gekennzeichnet, dass** das Ausgangssubstrat vor dem Loslösen über die freiliegende Fläche in innigen Kontakt mit einem Wirtssubstrat gebracht wird.

5. Verfahren nach Anspruch 4, **dadurch gekennzeichnet, dass** die Aufbrechbehandlung, im Vorfeld der Herstellung dieses innigen Kontakts, die Anwendung einer Behandlung zum Brüchigmachen des Ausgangssubstrats aufweist, wobei diese eine Wärmebehandlung aufweist und mindestens 85 % des thermomechanischen Aufwands entspricht, der erforderlich ist, um das Ausgangssubstrat bis zur Eindringtiefe des Wasserstoffs aufzubrechen, sowie, nach der Herstellung dieses innigen Kontakt, die Anwendung einer Behandlung zur Vollendung des Aufbrechens.

6. Verfahren nach Anspruch 5, **dadurch gekennzeichnet, dass** die Aufbrechbehandlung die Anwendung mechanischer Belastungen aufweist.

7. Verfahren nach Anspruch 5 oder Anspruch 6, **dadurch gekennzeichnet, dass** die Wärmebehandlung zur Brüchigmachen bei einer Temperatur von höchstens 400 °C durchgeführt wird.

8. Verfahren nach einem beliebigen der Ansprüche 5 bis 7, **dadurch gekennzeichnet, dass** die Behandlung zur Vollendung des Aufbrechens eine Wärmebehandlung aufweist, die bei einer Temperatur von höchstens 250 °C durchgeführt wird.

9. Verfahren nach Anspruch 5 bis 8, **dadurch gekennzeichnet, dass** die Behandlung zur Vollendung des Aufbrechens die Anwendung mechanischer Belastungen aufweist und bei Raumtemperatur durchgeführt wird.

10. Verfahren nach Anspruch 9, **dadurch gekennzeichnet, dass** die Behandlung zur Vollendung des Aufbrechens die Anwendung von Ultraschall oder die Anwendung von Mikrowellen aufweist.

11. Verfahren nach einem beliebigen der Ansprüche 1 bis 10, **dadurch gekennzeichnet, dass** die eindringende Dosis an Helium im Bereich von 1.10¹⁷ bis 2.10¹⁷ He⁺/cm² liegt, und dadurch, dass die eindringende Dosis an Wasserstoff im Bereich von 1.10¹⁷ bis 2.10¹⁷ H⁺/cm² liegt.

12. Verfahren nach einem beliebigen der Ansprüche 1 bis 11, **dadurch gekennzeichnet, dass** die eindringende Gesamtdosis ungefähr im Bereich von 3.10¹⁷ Atomen/cm² bis 4.5 10¹⁷ Atomen/cm² liegt.

13. Verfahren nach einem beliebigen der Ansprüche 1 bis 12, **dadurch gekennzeichnet, dass** die Eindringenergie für den Schritt des Eindringenlassens von Helium höher als die Eindringenergie von Wasserstoff ist.

14. Verfahren zur Herstellung einer GaN-Dünnschicht auf Grundlage eines Ausgangssubstrats, wobei mindestens ein verstärkter Oberflächenbereich, der sich entlang einer freiliegenden Fläche des Ausgangssubstrats erstreckt, aus GaN ist, wobei es die folgenden Schritte umfasst:
- Beschuss der freiliegenden Fläche des Ausgangssubstrats (11) mit Heliumionen (12) und anschließend möglicherweise mit Wasserstoffionen (12'), wobei das Helium als erstes in Tiefenrichtung des verstärkten Bereichs eindringen gelassen wird, wobei die eindringende Gesamtdosis im Bereich von 3.10¹⁷ Atomen/cm² bis 4.5 10¹⁷ Atomen/cm² liegt, wobei sie zumindest überwiegend aus Helium besteht,
- Anwenden einer Aufbrechbehandlung auf das Ausgangssubstrat, wobei diese dazu geeignet ist, das Loslösen des gesamten Abschnitts des verstärkten GaN-Bereichs (15), welcher sich zwischen der freiliegenden Fläche und der Eindringtiefe (13) des Heliums befindet, von einem Überrest des Ausgangssubstrats zu bewirken.

15. Verfahren nach Anspruch 14, **dadurch gekennzeichnet, dass** die eindringende Dosis vollständig aus Helium besteht, in der Größenordnung von ungefähr 4.10¹⁷/cm².

## Claims

1. Method of fabrication of a thin layer of GaN from a starting substrate of which at least a thick surface area along a starting substrate free face is in GaN, comprising the following steps:
- bombardment of said free face of the starting substrate (11) with helium (12) and hydrogen (12') ions,
- application to the starting substrate of a fracture treatment adapted to cause the detachment from a remainder of the starting substrate of all the portion of the thick area of GaN (15) situated between the free face and the implantation depth (13) of the helium and of the hydrogen, **characterized in that** the helium is implanted first in the thickness of said thick area and the hydrogen is implanted second, the doses of helium and of hydrogen each being between 1.10¹⁷ atoms/cm² and 4.10¹⁷ atoms/cm².

2. Method according to Claim 1, **characterized in that** the implantation dose of the helium is at least equal to the implantation dose of the hydrogen.

3. Method according to Claim 1 or Claim 2, **characterized in that** the remainder of the starting substrate after fracture is recycled and **in that** it further includes a treatment of preparation of the remainder of the starting substrate, before its recycling, involving at most one polishing of at most 1 micron thickness.

4. Method according to any one of Claims 1 to 4, **characterized in that** the starting substrate is, before the detachment, brought into intimate contact with a host substrate via said free face.

5. Method according to Claim 4, **characterized in that** the fracture treatment includes the application to the starting substrate, before this bringing into intimate contact, of an embrittlement treatment including a heat treatment and corresponding to at least 85% of the thermo-mechanical budget necessary for obtaining the fracture of this starting substrate at the implantation depth of the hydrogen, then after this bringing into intimate contact, the application of a residual fracture treatment.

6. Method according to Claim 5, **characterized in that** the embrittlement treatment includes the application of mechanical stresses.

7. Method according to Claim 5 or Claim 6, **characterized in that** the embrittlement heat treatment is effected at a temperature of at most 400°C.

8. Method according to any one of Claims 5 to 7, **characterized in that** the residual fracture treatment includes a heat treatment and is effected at a temperature at most equal to 250°C.

9. Method according to Claim 5 to 8, **characterized in that** the residual fracture treatment includes the application of mechanical stresses and is effected at room temperature.

10. Method according to Claim 9, **characterized in that** the residual fracture treatment includes the application of ultrasound or the application of microwaves.

11. Method according to any one of Claims 1 to 10, **characterized in that** the implantation dose of helium is between 1.10¹⁷ and 2.10¹⁷ He⁺/cm² and **in that** the implantation dose of hydrogen is in the range from 1.10¹⁷ and 2.10¹⁷ H⁺/cm².

12. Method according to any one of Claims 1 to 11, **characterized in that** the cumulative implantation dose is between 3.10¹⁷ atoms/cm² and 4.5 10¹⁷ atoms/cm², approximately.

13. Method according to any one of Claims 1 to 12, **characterized in that** the implantation energy for the helium implantation step is greater than the hydrogen implantation energy.

14. Method of fabrication of a thin layer of GaN from a starting substrate of which at least a thick surface area along a free face of the starting substrate is in GaN, comprising the following steps:
- bombardment of said free face of the starting substrate (11) with helium (12) ions and then, optionally, hydrogen (12') ions, the helium being implanted first in the thickness of said thick area, the cumulative implantation dose being between 3.10¹⁷ atoms/cm² and 4.5 10¹⁷ atoms/cm² inclusive, consisting at least in the most part of helium,
- application to the starting substrate of a fracture treatment adapted to cause the detachment from a remainder of the starting substrate of all the portion of the thick area of GaN (15) situated between the free face and the implantation depth (13) of the helium.

15. Method according to Claim 14, **characterized in that** the implantation dose consists entirely of helium, at about approximately 4.10¹⁷/cm².
